# EUROPEAN PATENT APPLICATION

(11) **EP 3 883 133 A1**
(43) Date of publication of application: **22.09.2021**
(21) Application number: 19902311.0
(22) Date of filing: 24.12.2019
(51) Int. Cl.: H03M 7/30

(54) **DATA COMPRESSION METHOD AND APPARATUS**

(30) Priority: 26.12.2018 CN 201811604685
(71) Applicant: Huawei Technologies Co., Ltd., Shenzhen Guangdong 518129 (CN)
(72) Inventor: NIU, Jinbao, Shenzhen, Guangdong 518129 (CN); QUAN, Shaohui, Shenzhen, Guangdong 518129 (CN); TAN, Xiaodong, Shenzhen, Guangdong 518129 (CN)
(74) Representative: Maiwald Patent- und Rechtsanwaltsgesellschaft mbH
(86) International application number: PCT/CN2019/127736
(87) International publication number: WO 2020/135384

(57) **Abstract**

This application provides a data compression method and apparatus, and relates to the field of storage technologies. The method includes: After receiving to-be-stored first data, a storage device may determine whether the first data is hot write data, and compress the first data if the first data is not hot write data. This application is used, so that compression performance can be improved.

## Description

### TECHNICAL FIELD

This application relates to the field of storage technologies, and in particular, to a data compression method and apparatus.

### BACKGROUND

In the field of storage technologies, to save storage space, data is compressed before being stored. Currently, there are a plurality of general compression algorithms, and different compression algorithms have different compression ratios and compression performance. Generally, a higher compression ratio indicates worse compression performance, and on the contrary, a lower compression ratio indicates better compression performance.

In the related art, a same compression algorithm is used when storing data, and the same compression algorithm is used to compress all to-be-written data, so that relatively poor compression performance or a relatively low compression ratio may be caused.

### SUMMARY

To resolve a problem in the related art, embodiments of this application provide a data compression method and apparatus. The technical solution is as follows:

According to a first aspect, a data compression method is provided, and the method includes:
receiving first data, determining whether the first data is hot write data, and compressing the first data if the first data is not hot write data.

In the solution shown in the embodiments of this application, in a system, a storage device is used as a storage device of the system. When data is written into the storage device in the system, the storage device may receive the written data (referred to as the first data subsequently), then determine whether the first data is written for the first time, and determine whether the first data is hot write data if the first data is not written for the first time. If the storage device determines that the first data is not hot write data, a compression algorithm may be obtained, to compress the first data.

In a possible implementation, the compressing the first data includes: compressing the first data by using a first compression algorithm if the first data is cold read data; or compressing the first data by using a second compression algorithm if the first data is hot read data, where a compression ratio of the first compression algorithm is greater than a compression ratio of the second compression algorithm.

In the solution shown in the embodiments of this application, after determining that the first data is hot write data, the storage device may determine whether the first data is cold read data. If the storage device determines that the first data is cold read data, the pre-stored first compression algorithm can be obtained, and the first data is compressed by using the first compression algorithm, to obtain the compressed first data. If the storage device determines that the first data is not cold read data, the pre-stored second compression algorithm can be obtained, and the first data is compressed by using the second compression algorithm, to obtain the compressed first data. That is, if the first data is not hot write data, and is cold read data, the first compression algorithm is used for compression. If the first data is not hot write data, and is hot read data, the second compression algorithm is used for compression. In this way, if the data is cold read data but not hot write data, it indicates that the data is not frequently accessed and modified, and a compression algorithm (the first compression algorithm) with a relatively high compression ratio can be used for compression. If the data is hot read data but not hot write data, it indicates that the data may be frequently accessed and read, but a modification rate is relatively low, and a compression algorithm (the second compression algorithm) with high decompression performance can be used for compression.

In a possible implementation, the method further includes: storing the compressed first data to a first storage area.

The first storage area is used to store non-hot write data.

In the solution shown in the embodiments of this application, the storage device may perform control over storing the compressed first data to the first storage area. In this way, the non-hot write data is stored in the first storage area, and is separated from the hot write data.

In a possible implementation, the method further includes: receiving second data, determining whether the second data is hot write data, and storing the second data to a second storage area if the second data is hot write data.

In the solution shown in the embodiments of this application, in a system, a storage device is used as a storage device of the system. When data is written into the storage device in the system, the storage device may receive the written data (referred to as the second data subsequently).

The storage device then determines whether the second data is hot write data. If the second data is hot write data, the second data may not be compressed, and is directly stored to the second storage area. In this way, the hot write data and the non-hot write data can be stored separately.

In a possible implementation, the determining whether the first data is hot write data includes: if a difference between a current time point and a previous time point at which a storage address corresponding to the first data is written is greater than a first preset threshold, determining that the first data is not hot write data; or if a difference between a current time point and a previous time point at which a storage address corresponding to the first data is written is less than or equal to a first preset threshold, determining that the first data is hot write data.

In the solution shown in the embodiments of this application, when the storage device receives the first data, the current time point may be determined, the previous time point at which the storage address corresponding to the first data is written, that is, the previous time point at which the storage address corresponding to data to be updated by the first data is written, may be obtained, and the difference between the time point and the current time point may be determined. The storage device determines values of the difference and the first preset threshold. If the difference is greater than the first preset threshold, the storage device determines that the first data is not hot write data. If the difference is less than or equal to the first preset threshold, the storage device determines that the first data is hot write data. In this way, when the foregoing difference is greater than the first preset threshold, that the first data is not hot write data is determined. Because that an update time of the first data is relatively long, and the first data is not often rewritten, the first data is not hot write data. When the foregoing difference is less than or equal to the first preset threshold, that the first data is hot write data is determined. Because that an update time of the first data is relatively short, and the first data is often rewritten, the first data is hot write data. Therefore, it may be accurately determined that whether the data is hot write data.

In a possible implementation, the method further includes: if a quantity of times of reading data that is in the storage address corresponding to the first data within preset duration before the current time point is less than or equal to a second preset threshold, determining that the first data is cold read data; or if a quantity of times of reading data that is in the storage address corresponding to the first data within preset duration before the current time point is greater than the second preset threshold, determining that the first data is hot read data.

The preset duration may be preset and stored in the storage device, and the second preset threshold may be preset and stored in the storage device.

In the solution shown in the embodiments of this application, the storage device records a quantity of times of reading data that is in each storage address, and the quantity of times of reading increases by one when the data is read once. The storage device may obtain the quantity of times of reading the data in the storage address corresponding to the first data within the preset duration before the current time point, and determine values of the quantity of times of reading and the second preset threshold. If the quantity of times of reading is greater than the second preset threshold, the storage device may determine that the first data is hot read data. If the quantity of times of reading is less than or equal to the second preset threshold, the storage device may determine that the first data is cold read data. In this way, when the quantity of times of reading is greater than the second preset threshold, it indicates that the first data is frequently read, so that the storage device may determine that the first data is hot read data, and otherwise, the first data is cold read data. Therefore, it may be accurately determined that whether the data is hot read data.

According to a second aspect, a storage device is provided, and the storage device includes a processor and an interface, where the processor implements the data compression method according to the first aspect by performing an instruction.

According to a third aspect, a data compression apparatus is provided, and the apparatus includes one or more modules, where the one or more modules implement the data compression method according to the first aspect by performing an instruction.

According to a fourth aspect, a computer-readable storage medium is provided, and the computer-readable storage medium stores an instruction. When the computer-readable storage medium runs on a storage device, the storage device is enabled to perform the data compression method according to the first aspect.

According to a fifth aspect, a computer program product including an instruction is provided. When the computer program product runs on a storage device, the storage device is enabled to perform the data compression method according to the first aspect.

Beneficial effects brought by the technical solution provided in the embodiments of this application are at least as follows:

In the embodiments of this application, after receiving to-be-stored first data, the storage device determines whether the first data is hot write data, and compresses the first data if the first data is not hot write data. In this way, by determining whether the data is hot write data, different compression algorithms are selected based on different determining results, so that compression performance can be improved, or a compression ratio can be increased.

In addition, in the embodiments of this application, the compression performance can be improved, and corresponding decompression performance can also be improved.

### BRIEF DESCRIPTION OF DRAWINGS

FIG. 1 is a schematic diagram of a compression ratio and compression performance according to an embodiment of this application;
FIG. 2 is a schematic structural diagram of a storage device according to an embodiment of this application;
FIG. 3 is a schematic flowchart of a data compression method according to an embodiment of this application;
FIG. 4 is a schematic diagram of a container according to an embodiment of this application;
FIG. 5 is a schematic diagram of data storage according to an embodiment of this application;
FIG. 6 is a schematic structural diagram of a data compression apparatus according to an embodiment of this application; and
FIG. 7 is a schematic structural diagram of a data compression apparatus according to an embodiment of this application.

### DESCRIPTION OF EMBODIMENTS

To make the objectives, technical solutions, and advantages of this application clearer, the following further describes the embodiments of this application in detail with reference to the accompanying drawings.

For ease of understanding embodiments of this application, the following first introduces a system architecture, and concepts of terms related to the embodiments of this application.

The embodiments of this application may be applied to a storage device in the field of all-flash memory, where the storage device may be a server, a server cluster, a storage array, or the like, and may also be applied to the storage device in the field of non-all-flash memory.

A compression ratio is a ratio of a size of data after compression to the size of the data before compression.

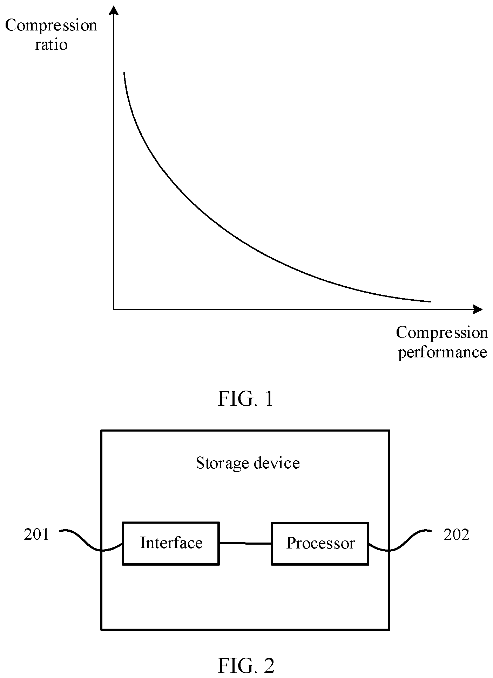

FIG. 1 shows a relationship between compression performance and the compression ratio. Generally, a higher compression ratio indicates worse compression performance and decompression performance, and a lower compression ratio indicates better compression performance and decompression performance.

An embodiment of this application provides a data compression method, and an execution body of the method may be the storage device.

FIG. 2 is a structural block diagram of a storage device according to an embodiment of this application, and the storage device may include at least an interface 201 and a processor 202. The interface 201 may be configured to implement data reception, and the specific implementation is that, the interface 201 may be a hardware interface such as a network interface card (Network Interface Card, NIC) or a host bus adaptor (Host Bus Adaptor, HBA), and may also be a program interface module. The processor 202 may be a combination of a central processing unit (Central Processing Unit, CPU) and a memory, and may further be a field programmable gate array (Field Programmable Gate Array, FPGA) or other hardware. The processor 202 is a control center of the storage device, and connects various parts of the storage device by using various interfaces and lines.

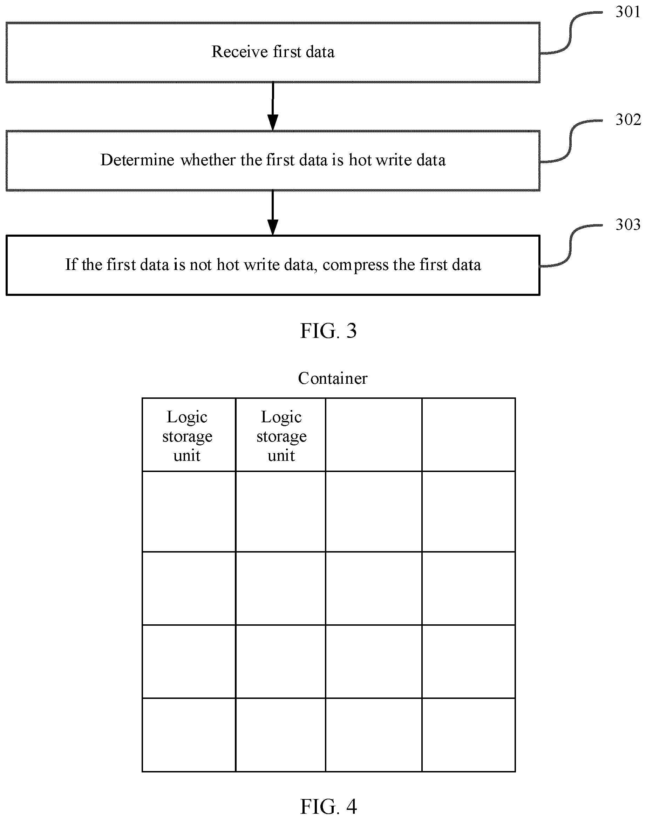

The following describes the processing flow shown in FIG. 3 in detail with reference to specific implementations. Content may be as follows.

### Step 301: Receive first data.

During implementation, in a system, the storage device is used as a storage device of the system. When data is written into the storage device in the system, the storage device may receive the written data (referred to as the first data subsequently).

Step 302: Determine whether the first data is hot write data.

During implementation, after receiving the first data, the storage device may determine whether the first data is written for the first time, and if not, determine whether the first data is hot write data.

In addition, if the storage device determines that the first data is written for the first time, a storage address of the first data is determined, and the first data is written into a storage area corresponding to the storage address. Alternatively, if the storage device determines that the first data is written for the first time, the storage address of the first data is determined, and then the first data is compressed by using a preset compression algorithm and stored to the storage area corresponding to the storage address.

It may be noted that, if the first data is not written for the first time, it indicates that the first data is to update the data that has been written in the storage device.

Optionally, there are many manners in this application to determine whether the first data is hot write data, and three feasible manners are provided below.

Manner 1: If a difference between a current time point and a previous time point at which the storage address corresponding to the first data is written is greater than a first preset threshold, it is determined that the first data is not hot write data. If the difference between the current time point and the previous time point at which the storage address corresponding to the first data is written is less than or equal to the first preset threshold, it is determined that the first data is hot write data.

The first preset threshold may be preset, for example, to three hours, and stored in the storage device.

During implementation, when the storage device receives the first data, the current time point may be determined, the previous time point at which the storage address corresponding to the first data is written, that is, the previous time point at which the storage address corresponding to data to be updated by the first data is written, may be obtained, and the difference between the time point and the current time point may be determined. Values of the difference and the first preset threshold are determined. If the difference is greater than the first preset threshold, the storage device determines that the first data is not hot write data. If the difference is less than or equal to the first preset threshold, the storage device determines that the first data is hot write data.

For example, the first preset threshold is 15 minutes, the previous time point at which the storage address of the first data is written is 10:15, and the current time point is 10:50. The difference between the two time points is 35 minutes, and is greater than the first preset threshold, so that the storage device may determine that the first data is not hot write data.

It may be noted that, when the foregoing difference is greater than the first preset threshold, the storage device determines that the first data is not hot write data. Because that an update time of the first data is relatively long, and the first data is not often rewritten, the first data is not hot write data. When the foregoing difference is less than or equal to the first preset threshold, that the first data is hot write data is determined. Because that an update time of the first data is relatively short, and the first data is often rewritten, the first data is hot write data.

Manner 2: Determine a container that the first data is to be written, and data blocks written in the container. The current time point is subtracted from a previous time point at which a storage address corresponding to each data block in the container is written, to obtain a difference of a written time of the storage address corresponding to the data block. A weight corresponding to a difference range to which the difference belongs is determined, and the difference corresponding to the data block is multiplied by the weight value corresponding to the difference range to which the difference corresponding to the data block belongs, to obtain a first product corresponding to the data block. The first products corresponding to the data blocks are added to obtain a first weighted value. If the first weighted value is greater than a third preset threshold, it is determined that the first data is not hot write data. If the first weighted value is less than or equal to the third preset threshold, it is determined that the first data is hot write data.

As shown in FIG. 4, the container (Container) is a logic storage unit in the storage device, and may store a plurality of data blocks. The third preset threshold may be preset and stored in the storage device.

During implementation, when the storage device receives the first data, the container (for example, a container may be selected randomly from writable containers) to be written and the written data blocks may be determined first, and then, the previous time point at which the storage address corresponding to the current each data block in the container is written can be determined. The current time point is subtracted from the previous time point at which the storage address corresponding to the data block in the container is written, to obtain the difference of the written time of the storage address corresponding to the data block. Then a correspondence between the pre-stored difference range and the weight is obtained. In the correspondence, the weight corresponding to the difference range to which the difference corresponding to the data block belongs is determined. For any data block, the difference corresponding to the data block is multiplied by the weight value corresponding to the difference range to which the difference corresponding to the data block belongs, to obtain the first product corresponding to the data block. The first products of all data blocks in the container are then added to obtain the first weighted value, and the first weighted value and a value of the third preset threshold are determined. If the first weighted value is greater than the third preset threshold, the storage device determines that the first data is not hot write data. If the first weighted value is less than or equal to the third preset threshold, the storage device determines that the first data is hot write data.

Manner 3: If the difference between the current time point and the previous time point at which the storage address corresponding to the first data is written is greater than the first preset threshold, it is determined that the first data is not hot write data. If the difference between the current time point and the previous time point at which the storage address corresponding to the first data is written is less than or equal to a fifth preset threshold, it is determined that the first data is hot write data.

The fifth preset threshold is less than the first preset threshold, and may also be preset and stored in the storage device.

During implementation, when the storage device receives the first data, the current time point may be determined, the previous time point at which the storage address corresponding to the first data is written, that is, the previous time point at which the storage address corresponding to data to be updated by the first data is written, may be obtained, and the difference between the time point and the current time point may be determined. The values of the difference and the first preset threshold are determined. If the difference is greater than the first preset threshold, the storage device determines that the first data is not hot write data. The value of the difference and a value of the fifth preset threshold may alternatively be determined. If the difference is less than or equal to the fifth preset threshold, the storage device determines that the first data is hot write data.

In addition, if the foregoing difference is greater than the fifth preset threshold, and is less than the first preset threshold, the storage device determines that the first data is warm write data.

Step 303: If the first data is not hot write data, compress the first data.

During implementation, if the storage device determines that the first data is not hot write data, a compression algorithm may be obtained to compress the first data.

In addition, when the first data is hot write data, it indicates that the first data is frequently modified, and there is little significance to compress this type of the data; therefore, no compression is performed.

Optionally, the first data may be compressed based on the type of the data, and corresponding processing may be as follows:

If the first data is not hot write data, and the first data is non-image data or non-video data, the first data is compressed.

During implementation, if the storage device determines that the first data is not hot write data, whether the first data is non-image data may be determined, and if the first data is non-image data, the first data may be compressed.

In addition, the first data is not compressed if it is not non-image data. Because that image data itself has been compressed, and the existing lossless compression algorithm cannot further compress the image data, the image data is not further compressed.

If the storage device determines that the first data is not hot write data, whether the first data is non-video data may be determined, and if the first data is non-video data, the first data may be compressed.

In addition, the first data is not compressed if it is not non-video data. Because that video data itself has been compressed, and the existing lossless compression algorithm cannot further compress the video data, the video data is not further compressed.

In addition, if the first data is not hot write data, but the first data is a log file, because each log file has a fixed format, the fixed format may be stored as a template, and other data is compressed by using the template as a reference. The compressed data only stores a difference between the compressed data and the template.

Optionally, the first data may alternatively be compressed based on read information of the first data, and corresponding processing may be as follows:
If the first data is cold read data, the first data is compressed by using a first compression algorithm. If the first data is hot read data, the first data is compressed by using a second compression algorithm.

The compression ratio of the first compression algorithm is greater than the compression ratio of the second compression algorithm. However, the compression performance of the first compression algorithm is lower than the compression performance of the second compression algorithm, and the decompression performance of the second compression algorithm is higher than the decompression performance of the first compression algorithm. For example, the first compression algorithm may be a lossless compression algorithm (Zstandard, ZSTD) with high compression ratio, or a lossless compression algorithm (GNUzip, GZIP) with high compression ratio. The second compression algorithm may be a high compression ratio algorithm with the same compression format as LZ4, and the algorithm may be Lempel-Ziv 4 with a high compression ratio (Abraham Lempel and Jacob Ziv with High compression ratio, LZ4HC), or the like.

During implementation, after determining that the first data is hot write data, the storage device may determine whether the first data is cold read data, if the storage device determines that the first data is cold read data, the pre-stored first compression algorithm can be obtained, and the first data is compressed by using the first compression algorithm, to obtain the compressed first data. If the storage device determines that the first data is not cold read data, the pre-stored second compression algorithm can be obtained, and the first data is compressed by using the second compression algorithm, to obtain the compressed first data. That is, if the first data is not hot write data, and is cold read data, the first compression algorithm is used for compression. If the first data is not hot write data, and is hot read data, the second compression algorithm is used for compression. In this way, if the data is cold read data but not hot write data, it indicates that the data is not frequently accessed and modified, and a compression algorithm (the first compression algorithm) with a relatively high compression ratio can be used for compression. If the data is hot read data but not hot write data, it indicates that the data may be frequently accessed and read, but a modification rate is relatively low, and a compression algorithm (the second compression algorithm) with high decompression performance can be used for compression.

It may be noted that, when the first compression algorithm is obtained, the first compression algorithm may be obtained from a pre-stored correspondence, the correspondence may be a correspondence between a read type and the compression algorithm, and the read type includes hot read data and cold read data. The correspondence may be as shown in Table 1:

**Table 1**

| Read type | Compression algorithm |
|---|---|
| Cold read data | First compression algorithm |
| Hot read data | Second compression algorithm |

Optionally, this application further provides processing to determine whether the first data is cold read data, and three corresponding processing manners may be as follows:

Manner 1: If a quantity of times of reading data that is in the storage address corresponding to the first data within preset duration before the current time point is less than or equal to a second preset threshold, it is determined that the first data is cold read data; or if a quantity of times of reading data that is in the storage address corresponding to the first data within preset duration before the current time point is greater than the second preset threshold, it is determined that the first data is hot read data.

The preset duration may be preset and stored in the storage device, and the second preset threshold may be preset and stored in the storage device.

During implementation, the storage device may record a quantity of times of reading data that is in each storage address, and the quantity of times of reading increases by one when the data is read once.

The storage device may obtain the quantity of times of reading the data in the storage address corresponding to the first data within the preset duration before the current time point, and determine values of the quantity of times of reading and the second preset threshold. If the quantity of times of reading is greater than the second preset threshold, the storage device may determine that the first data is hot read data, if the quantity of times of reading is less than or equal to the second preset threshold, the storage device may determine that the first data is cold read data.

For example, the second preset threshold is 20 times, the preset duration is two hours, the current time point is 10:50, and the quantity of times of reading the data in the storage address corresponding to the first data within the preset duration before the current time point is 30 times that is greater than the second preset threshold, the storage device may determine that the first data is hot read data.

It may be noted that, when the quantity of times of reading is greater than the second preset threshold, it indicates that the first data is frequently read, so that the storage device may determine that the first data is hot read data, and otherwise, the first data is cold read data.

Manner 2: Determine the container that the first data is to be written, and the data blocks written in the container. The quantity of times of reading the storage address corresponding to each data block within the preset duration before the current time point is determined. A weight corresponding to a range that is of the quantity of times of reading and to which the quantity of times of reading belongs is determined, and the quantity of times of reading is multiplied by the weight corresponding to the range of the quantity of times of reading, to obtain a second product corresponding to the data block. The second products corresponding to the data blocks are added to obtain a second weighted value. If the second weighted value is greater than a fourth preset threshold, it is determined that the first data is hot read data. If the second weighted value is less than or equal to the fourth preset threshold, it is determined that the first data is cold read data.

The container (Container) is a logic storage unit in the storage device, and may store a plurality of data blocks. The preset duration may be the same as the preset duration described above, the fourth preset threshold may be preset and stored in the storage device.

During implementation, when the storage device receives the first data, the container to be written and the written data blocks may be determined first, and then, a time period within the preset duration from the current time point is determined, the quantity of times of reading the storage address corresponding to the data block in the period is obtained, and the correspondence between the pre-stored range of the quantity of times of reading and the weight is obtained. From the correspondence, the weight corresponding to the range that is of the quantity of times of reading and to which the quantity of times of reading belongs corresponding to the data block is determined. In this way, the weight corresponding to the data block can be obtained. For any data block, the weight corresponding to the data block is multiplied by the quantity of times of reading corresponding to the data block, to obtain the second product corresponding to the data block. The second products corresponding to all the data blocks in the container are added to obtain the second weighted value.

The second weighted value and a value of the fourth preset threshold are determined. If the second weighted value is greater than the fourth preset threshold, the storage device determines that the first data is hot read data. If the second weighted value is less than or equal to the fourth preset threshold, the storage device determines that the first data is cold read data.

Manner 3: If the quantity of times of reading the data in the storage address corresponding to the first data within preset duration before the current time point is less than or equal to the second preset threshold, the storage device determines that the first data is cold read data, and if the quantity of times of reading the data in the storage address corresponding to the first data within the preset duration before the current time point is greater than a sixth preset threshold, the storage device determines that the first data is hot read data.

The sixth preset threshold is greater than the second preset threshold, and may also be preset and stored in the storage device.

During implementation, the storage device may obtain the quantity of times of reading the data in the storage address corresponding to the first data within the preset duration before the current time point, and determine the values of the quantity of times of reading and the second preset threshold. If the quantity of times of reading is less than or equal to the second preset threshold, the storage device determines that the first data is cold read data. The value of the quantity of times of reading and a value of the sixth preset threshold may alternatively be determined. If the quantity of times of reading is greater than the sixth preset threshold, the storage device determines that the first data is hot read data.

In addition, if the foregoing quantity of times of reading is greater than the second preset threshold, and is less than or equal to the sixth preset threshold, the storage device determines that the first data is warm read data.

Optionally, an embodiment of this application further provides processing of storing the compressed first data to a storage area, and corresponding processing may be as follows:

The compressed first data is stored to a first storage area.

The first storage area is used to store non-hot write data.

During implementation, a storage device may perform control over storing the compressed first data to the first storage area.

Optionally, an embodiment of this application further provides a storage process of hot write data, and corresponding processing may be as follows:
Second data is received, and whether the second data is hot write data is determined. If the second data is hot write data, the second data is stored to a second storage area.

During implementation, in a system, the storage device is used as a storage device of the system. When data is written into the storage device in the system, the storage device may receive the written data (referred to as the second data subsequently).

The storage device then determines whether the second data is hot write data, and if the second data is hot write data, the second data may not be compressed, and is directly stored to the second storage area.

It may be noted that, the second storage area is different from the first storage area described above. The first storage area stores the compressed data, and the second storage area stores the uncompressed data.

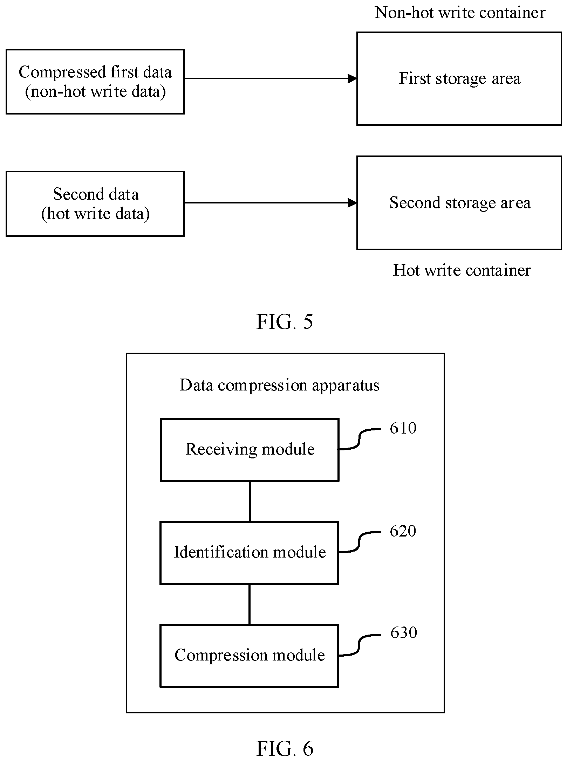

For example, as shown in FIG. 5, the first storage area is a non-hot write container, and the second storage area is a hot write container, which are respectively used to store non-hot write data and hot write data.

In this way, by storing the hot write data and the non-hot write data separately, the hot write data is often rewritten, and garbage collection (Garbage Collection, GC) may be performed. However, the non-hot write data is not often rewritten, and generally, the garbage collection is not performed, so that efficiency of the garbage collection may be improved.

In addition, for the warm write data and warm read data described above, if a piece of data is the warm write data and the warm read data, the compression algorithm may be a dictionary compression algorithm (Abraham Lempel and Jacob Ziv, LZ4).

According to this application, an end-to-end reduction rate may be increased to more than 20%, and an impact on overall performance of the storage device is less than 5%.

In the embodiments of this application, after receiving to-be-stored first data, the storage device determines whether the first data is hot write data, and compresses the first data if the first data is not hot write data. In this way, by determining whether the data is hot write data, different compression algorithms are selected based on different determining results, so that compression performance can be improved, or a compression ratio can be increased.

In addition, in the embodiments of this application, the compression performance can be improved, and corresponding decompression performance can also be improved.

FIG. 6 is a structural diagram of a data compression apparatus according to an embodiment of this application. The apparatus may be implemented as a part or the entire of the apparatus by using software, hardware, or a combination thereof. The apparatus provided in this embodiment of this application may implement the process described in FIG. 2 according to the embodiments of this application, and the apparatus includes: a receiving module 610, an identification module 620, and a compression module 630, where:
the receiving module 610 is configured to receive first data, and may be specifically configured to perform step 301 and implicit steps included in step 301;
the identification module 620 is configured to determine whether the first data is hot write data, and may be specifically configured to perform step 302 and implicit steps included in step 302; and
the compression module 630 is configured to compress the first data when the first data is not hot write data, and may be specifically configured to perform step 303 and implicit steps included in step 303.

Optionally, the compression module 630 is configured to:
if the first data is cold read data, compress the first data by using a first compression algorithm, or
if the first data is hot read data, compress the first data by using a second compression algorithm, where a compression ratio of the first compression algorithm is greater than a compression ratio of the second compression algorithm.

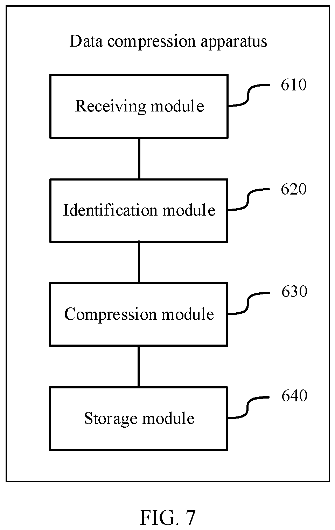

Optionally, as shown in FIG. 7, the apparatus further includes:
a storage module 640, configured to store the compressed first data to a first storage area.

Optionally, the receiving module 610 is further configured to receive second data;
the identification module 620 is further configured to determine whether the second data is hot write data; and
the apparatus further includes:
   the storage module 640, configured to store the second data to a second storage area if the second data is hot write data.

Optionally, the identification module 620 is configured to:
if a difference between a current time point and a previous time point at which the storage address corresponding to the first data is written is greater than a first preset threshold, determine that the first data is not hot write data, or if a difference between a current time point and a previous time point at which the storage address corresponding to the first data is written is less than or equal to a first preset threshold, determine that the first data is hot write data.

Optionally, the identification module 620 is further configured to:
if a quantity of times of reading data that is in the storage address corresponding to the first data within preset duration before the current time point is less than or equal to a second preset threshold, determine that the first data is cold read data, or if a quantity of times of reading data that is in the storage address corresponding to the first data within preset duration before the current time point is greater than the second preset threshold, determine that the first data is hot read data.

In the embodiments of this application, after receiving to-be-stored first data, the storage device determines whether the first data is hot write data, and compresses the first data if the first data is not hot write data. In this way, by determining whether the data is hot write data, different compression algorithms are selected based on different determining results, so that compression performance can be improved, or a compression ratio can be increased.

In addition, in the embodiments of this application, the compression performance can be improved, and corresponding decompression performance can also be improved.

For a specific implementation of the data compression apparatus shown in FIG. 6 according to the embodiments of this application, reference may be made to the storage device described in FIG. 2.

It should be noted that when the data compression apparatus provided in the foregoing embodiment is performing data compression, division into the foregoing functional modules is used only as an example for description. In actual application, the foregoing functions can be allocated to and implemented by different functional modules based on a requirement, that is, an inner structure of the apparatus is divided into different functional modules, to implement all or some of the functions described above. In addition, the data compression apparatus and data compression method embodiments provided in the foregoing embodiments are based on a same concept. For details about a specific implementation process, refer to the method embodiment. Details are not described herein again.

All or some of the foregoing embodiments may be implemented by using software, hardware, firmware, or any combination thereof. When the software is used for implementation, all or some of the embodiments may be implemented in a form of a computer program product. The computer program product includes one or more computer instructions. When the computer program instructions are loaded and executed on a server or a terminal, all or some of the procedures or functions according to the embodiments of this application are generated. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial optical cable, an optical fiber, or a digital subscriber line) or wireless (for example, infrared, radio, or microwave) manner. The computer-readable storage medium may be any usable medium accessible by a server or a terminal, or a data storage device, such as a server or a data center, integrating one or more usable media. The usable medium may be a magnetic medium (for example, a floppy disk, a hard disk, or a magnetic tape), an optical medium (for example, a digital video disk (Digital Video Disk, DVD)), or a semiconductor medium (for example, a solid-state drive).

## Claims

1. A data compression method, wherein the method comprises:
receiving first data;
determining whether the first data is hot write data; and
compressing the first data if the first data is not hot write data.

2. The method according to claim 1, wherein the compressing the first data comprises:
compressing the first data by using a first compression algorithm if the first data is cold read data; or
compressing the first data by using a second compression algorithm if the first data is hot read data, wherein a compression ratio of the first compression algorithm is greater than a compression ratio of the second compression algorithm.

3. The method according to claim 1 or 2, wherein the method further comprises:
storing the compressed first data to a first storage area.

4. The method according to any one of claims 1 to 3, wherein the method further comprises:
receiving second data;
determining whether the second data is hot write data; and
storing the second data to a second storage area if the second data is hot write data.

5. The method according to any one of claims 1 to 4, wherein the determining whether the first data is hot write data comprises:
if a difference between a current time point and a previous time point at which a storage address corresponding to the first data is written is greater than a first preset threshold, determining that the first data is not hot write data; or if a difference between a current time point and a previous time point at which a storage address corresponding to the first data is written is less than or equal to a first preset threshold, determining that the first data is hot write data.

6. The method according to claim 2, wherein the method further comprises:
if a quantity of times of reading data that is in a storage address corresponding to the first data within preset duration before a current time point is less than or equal to a second preset threshold, determining that the first data is cold read data; or if a quantity of times of reading data that is in a storage address corresponding to the first data within preset duration before a current time point is greater than the second preset threshold, determining that the first data is hot read data.

7. A data compression storage device, wherein the storage device comprises an interface and a processor, wherein
the interface is configured to receive first data; and
the processor is configured to:
determine whether the first data is hot write data, and
compress the first data if the first data is not hot write data.

8. The storage device according to claim 7, wherein the processor is configured to:
compress the first data by using a first compression algorithm if the first data is cold read data; or
compress the first data by using a second compression algorithm if the first data is hot read data, wherein a compression ratio of the first compression algorithm is greater than a compression ratio of the second compression algorithm.

9. The storage device according to claim 7 or 8, wherein the processor is further configured to:
store the compressed first data to a first storage area.

10. The storage device according to any one of claims 7 to 9, wherein the interface is further configured to receive second data; and
the processor is further configured to:
determine whether the second data is hot write data, and
store the second data to a second storage area if the second data is hot write data.

11. The storage device according to any one of claims 7 to 10, wherein the processor is configured to:
if a difference between a current time point and a previous time point at which a storage address corresponding to the first data is written is greater than a first preset threshold, determine that the first data is not hot write data; or if a difference between a current time point and a previous time point at which a storage address corresponding to the first data is written is less than or equal to a first preset threshold, determine that the first data is hot write data.

12. The storage device according to claim 8, wherein the processor is further configured to:
if a quantity of times of reading data that is in a storage address corresponding to the first data within preset duration before a current time point is less than or equal to a second preset threshold, determine that the first data is cold read data; or if a quantity of times of reading data that is in a storage address corresponding to the first data within preset duration before a current time point is greater than the second preset threshold, determine that the first data is hot read data.

13. A data compression apparatus, wherein the apparatus comprises:
a receiving module, configured to receive first data;
an identification module, configured to determine whether the first data is hot write data; and
a compression module, configured to compress the first data if the first data is not hot write data.

14. The apparatus according to claim 13, wherein the compression module is configured to:
compress the first data by using a first compression algorithm if the first data is cold read data; or
compress the first data by using a second compression algorithm if the first data is hot read data, wherein a compression ratio of the first compression algorithm is greater than a compression ratio of the second compression algorithm.

15. The apparatus according to claim 13 or 14, wherein the apparatus further comprises:
a storage module, configured to store the compressed first data to a first storage area.

16. The apparatus according to any one of claims 13 to 15, wherein the receiving module is further configured to receive second data;
the identification module is further configured to determine whether the second data is hot write data; and
the apparatus further comprises:
the storage module, configured to store the second data to a second storage area if the second data is hot write data.

17. The apparatus according to any one of claims 13 to 16, wherein the identification module is configured to:
if a difference between a current time point and a previous time point at which a storage address corresponding to the first data is written is greater than a first preset threshold, determine that the first data is not hot write data; or if a difference between a current time point and a previous time point at which a storage address corresponding to the first data is written is less than or equal to a first preset threshold, determine that the first data is hot write data.

18. The apparatus according to claim 14, wherein the identification module is further configured to:
if a quantity of times of reading data that is in a storage address corresponding to the first data within preset duration before a current time point is less than or equal to a second preset threshold, determine that the first data is cold read data; or if a quantity of times of reading data that is in a storage address corresponding to the first data within preset duration before a current time point is greater than the second preset threshold, determine that the first data is hot read data.

19. A computer-readable storage medium, wherein the computer-readable storage medium stores instructions. When the computer-readable storage medium runs on a storage device, the storage device is enabled to perform the method according to any one of claims 1 to 6.

20. A computer program product comprising an instruction, wherein when the computer program product runs on a storage device, the storage device is enabled to perform the method according to any one of claims 1 to 6.
